# FASCICULE DE BREVET EUROPEEN

(11) **EP 0 710 298 B1**
(45) Date de publication et mention de la délivrance du brevet: **11.06.1997**
(21) Numéro de dépôt: 94922933.0
(22) Date de dépôt: 18.07.1994
(51) Int. Cl.: C23C 2/26, C23C 14/48, B05D 3/14

(54) **PROCEDE POUR PREPARER UNE TOLE EN ACIER REVETUE DE ZINC OU D'ALLIAGE DE ZINC EN VUE DE MISE EN PEINTURE PAR UTILISATION DE LA TECHNIQUE DU BOMBARDEMENT IONIQUE**
VERFAHREN ZUM VORBEREITEN EINES MIT ZINK ODER ZINKLEGIERUNG BESCHICHTETER STAHLBLECHE FÜR DIE LACKIERUNG BEI VERWENDUNG DER IONENBESCHUSSTECHNIK
METHOD OF ION BOMBARDING A ZINC OR ZINC ALLOY COATED STEEL SHEET BEFORE PAINTING THEREOF

(30) Priorité: 20.07.1993 FR 9308905
(43) Date de publication de la demande: 08.05.1996
(73) Titulaire: SOLLAC, F-92800 Puteaux (FR)
(72) Inventeur: CHOQUET, Patrick, F-42100 Saint-Etienne (FR); GUESDON, Philippe, F-75018 Paris (FR); LE DUC, Hiep, F-57000 Metz (FR)
(74) Mandataire: Le Guen, Gérard
(86) Numéro de dépôt international: FR9400895
(87) Numéro de publication internationale: WO9503435

(56) Documents cités:
- EP-A- 0 372 634
- BE-A- 663 239
- US-A- 5 182 000
- POLYMER PREPRINTS, vol. 34, no. 1, Mars 1993, DENVER,US, pages 693-694, D.B. ZEIK: "structural characteristics and properties of plasma-polymerized films of hexamethyldisloxane on metal substrates"
- PATENT ABSTRACTS OF JAPAN vol. 11, no. 282 (C-446), 11 Septembre 1987 & JP 62 080260 A (NIPPON KOKAN), 13 Avril 1987,
- DATABASE WPI Derwent Publications Ltd., London, GB; AN 83-798842 C43 "zinc and iron plated steel sheet" & JP 58 157 989 A (KAWASAKI STEEL) , 20 Septembre 1983
- DATABASE WPI Derwent Publications Ltd., London, GB; AN 83-798843 "surface finishing steel sheet" & JP 58 157 990 A (KAWASAKI STEEL) , 20 Septembre 1983
- DATABASE WPI Derwent Publications Ltd., London, GB; AN 92-044500 C06 "galvanised steel plate" & JP 03 287 753 A (SUMITOMO METAL IND) , 18 Décembre 1991
- PATENT ABSTRACTS OF JAPAN vol. 17, no. 180 (C-1046), 8 Avril 1993 & JP 04 337059 A (NIPPON STEEL CORP), 25 Novembre 1992,
- DATABASE WPI Derwent Publications Ltd., London, GB; AN 83-810954 C45 "discharge hardening treatment of metal surface" & JP 58 164 717 A (AGENCY OF IND SCI TECH) , 29 Septembre 1983

## Description

La présente invention concerne un traitement de surface préparatoire d'une tôle d'acier revêtue de zinc en vue de sa mise en peinture.

Comme on le sait, des progrès considérables ont été réalisés durant ces dernières années dans le but d'améliorer la qualité des tôles d'acier revêtues de zinc ou d'alliage de zinc. Cependant, diverses améliorations, notamment en terme d'aspect de surface de la tôle, apparaissent toujours souhaitables pour l'obtention d'un meilleur aspect après peinture.

L'invention a pour but de proposer une nouvelle technique de préparation d'une telle tôle en vue de sa mise en peinture qui permette d'améliorer notamment l'aspect de surface de la tôle peinte.

A cet effet, l'invention a pour oojet un procédé pour préparer une tôle en acier revêtue de zinc ou d'alliage de zinc en vue de sa mise en peinture ultérieure, utilisant la technique du bombardement ionique.

Le traitement préparatoire selon l'invention prévoit que l'on fait subir à ladite tôle sur au moins une des faces revêtues, préalablement à sa mise en peinture, un bombardement ionique sous vide par des ions d'au moins un gaz neutre, ou d'au moins un gaz réactif, ou d'un mélange formé d'au moins un gaz neutre et d'au moins un gaz réactif, ces ions ayant une énergie et une densité suffisantes pour modifier l'état de surface de la tôle par érosion ionique, par effet thermo-ionique ou par effet chimique, ou par au moins deux de ces phénomènes cumulés.

Le gaz neutre peut être avantageusement choisi parmi l'argon, le xénon, et le krypton. Le gaz réactif est de préférence choisi parmi l'oxygène, le fluor, l'hydrogène et les hydrocarbures volatils. Lorsque le gaz réactif est un hydrocarbure volatil, il produit, dans les conditions d'ionisation mises en oeuvre pour le bombardement ionique, des ions carbone. Le traitement préparatoire sous vide selon l'invention vise à modifier l'état de surface de la tôle revêtue de zinc ou d'alliage de zinc, sous l'action des ions bombardés.

Dans ce but, les ions ont une énergie comprise de préférence entre 500 et 2000 eV, plus préférentiellement entre 750 et 1000 eV, par exemple de l'ordre de 850 eV.

La densité des ions est avantageusement de 10¹⁵ à lO¹⁸ ions/cm², par exemple de 5.10¹⁶ ions/cm².

Le traitement de la tôle s'effectue en plaçant la tôle dans un plasma ionique dans une enceinte sous vide dans laquelle la pression est avantageusement de 10² à 10⁻² Pa, de préférence de 1 à 10⁻² Pa et par exemple de 5.10⁻¹ Pa.

Un tel traitement peut-être effectué pendant une durée de 3 min.

La surface du substrat zingué est ainsi modifiée par érosion ionique, par effet thermo-ionique superficiel ou par effet chimique. Plusieurs de ces phénomènes peuvent se produire simultanément.

En particulier, le bombardement ionique peut conduire à un enlèvement de matière de la surface de la tôle.

Après le bombardement ionique, la tôle est prête à être mise en peinture sur la ou les faces bombardées selon un procédé de peinture connu en soi.

Pour cela la tôle est retirée de l'enceinte sous vide et est acheminée à une pression plus élevée vers l'unité de mise en peinture.

L'invention a donc également pour objet un procédé de mise en peinture d'une tôle en acier revêtue de zinc ou d'alliage de zinc, caractérisé en ce que, avant l'étape de mise en peinture proprement dite, la tôle est soumise sur au moins une de ses faces revêtues à un traitement préparatoire par bombardement ionique sous vide tel que décrit précédemment.

En effet, le traitement préparatoire sous vide effectué avant l'application de la peinture conduit à une amélioration en terme d'aspect après peinture du produit, tout en assurant de bonnes conditions d'adhérence du film de peinture sur ledit produit.

Cette solution est simple et économique, tout en respectant l'environnement en évitant de créer des problèmes de pollution, grâce à l'utilisation d'une enceinte sous vide.

Ces résultats avantageux peuvent s'expliquer par le fait que le bombardement par plasma sous vide modifie l'état de surface de la tôle, notamment augmente sa rugosité.

De manière surprenante, on obtient l'amélioration de l'aspect après peinture de la tôle malgré l'augmentation de rugosité de la surface de la tôle avant peinture due au traitement par bombardement ionique.

Des tôles en acier revêtues de peinture selon l'invention sont particulièrement avantageuses en raison de leur bel aspect de surface. L'invention a donc enfin pour objet de telles tôles d'acier revêtues comprenant une couche de base constituée de zinc ou d'alliage de zinc déposée sur l'acier et une couche de peinture appliquée sur ladite couche de base, caractérisées en ce que l'état de surface de la couche de base a été modifié, avant l'application de ladite couche de peinture, par un traitement par bombardement ionique sous vide tel que décrit précédemment.

Les essais suivants illustrent l'invention.

### Essai 1 :

Le but de cet essai est de montrer l'amélioration de l'aspect d'une tôle d'acier revêtue de zinc ou d'alliage de zinc, et plus particulièrement d'une tôle d'acier galvanisée à chaud, traitée selon l'invention avant sa mise en peinture par rapport à l'aspect d'une tôle d'acier revêtue de zinc ou d'alliage de zinc, et plus particulièrement d'une tôle d'acier galvanisée à chaud et peinte.

L'essai est effectué sur deux échantillons de tôles d'acier galvanisées à chaud, 1 et 2 qui reçoivent de manière classique un revêtement de zinc par galvanisation à chaud, c'est-à-dire par trempé à chaud dans un bain comprenant principalement du zinc. Le revêtement ainsi déposé comprend en masse 0,5% d'aluminium, 0,46% de fer, 0,03% de plomb et quelques impuretés résiduelles, le reste étant constitué par le zinc. L'épaisseur de ce revêtement est d'environ 11µm et l'épaisseur totale de la tôle munie de ce revêtement est de 0,75mm.

L'échantillon 2 est placé dans une enceinte sous vide dont l'atmosphère est à une pression de 10⁻²Pa et l'on soumet les faces à revêtir dudit échantillon à un bombardement ionique au moyen d'ions de gaz neutre, obtenus à partir d'argon.

Ces ions ont une énergie égale à 500 eV et la densité de courant ionique est de 0,16 mA/cm².

Le traitement de surface précité est effectué pendant une durée de 3mn. L'échantillonl n'est pas traité et sert de témoin.

Ensuite, on effectue sur les deux échantillons diverses opérations largement connues de l'art antérieur: dégraissage alcalin, rinçage, affinage, phosphatation tricationique, rinçage, passivation chromique, rinçage, étuvage.

Les échantillons sont ensuite soumis à une opération de cataphorèse de type PPG ED4 717/958 permettant d'appliquer une première couche de peinture d'épaisseur égale à 25µm sur chacun d'eux, On applique ensuite une couche d'apprêt d'épaisseur d'environ 45µm suivie d'une cuisson et une couche de laque d'environ 45µm suivie également d'une cuisson. Cet essai consiste à mesurer le DOI (Distinctness of image) de ces échantillons ainsi peints, c'est-à-dire à révéler l'aptitude de la surface desdits échantillons à réfléchir des images plus ou moins nettes, la mesure du DOI prenant en compte la tension et le brillant du film peint. Pour effectuer la mesure du DOI des surfaces peintes des échantillons let 2, on utilise un appareil commercialisé par la société CHIMILAB ESSOR et comportant une mire transparente sur laquelle sont représentés des anneaux ouverts répartis en plusieurs zones parallèles juxtaposées : la première de ces zones est occupée par plusieurs anneaux identiques de diamètre élevé, et une cotation 10 est figurée en regard de cette zone. Ainsi, de proche en proche, les zones suivantes sont occupées par des anneaux identiques de diamètre de plus en plus réduit, auxquelles correspondent respectivement des cotations de.plus en plus élevées, par saut de 10 et allant jusqu'à 100.

Pour chaque échantillon, on projette l'image de la mire sur l'une des faces de celui-ci à l'aide d'une lumière, et l'opérateur effectuant l'essai donne une cotation correspondant au plus petit anneau parfaitement visible lorsqu'il observe la surface peinte sous un angle d'incidence de 30°.

Les résultats de l'essai affichent une cotation de 85 pour l'échantillon non traité 1, et une cotation de 95 pour l'échantillon 2, prouvant par là même l'amélioration de l'aspect des tôles d'acier galvanisées à chaud traitées selon l'invention avant leur mise en peinture.

### Essai 2:

Cet essai a pour but de montrer que le traitement selon l'invention modifie la microgéométrie de surface d'une tôle d'acier revêtue de zinc ou d'alliage de zinc, et plus particulièrement d'une tôle d'acier galvanisée à chaud.

Quatre échantillons de tôles d'acier numérotés de 1 à 4 sont trempés à chaud dans un bain en vue de déposer sur chacune de leurs faces principales un revêtement de zinc.

Les échantillons 1 et 2 sont immergés dans un bain comprenant principalement du zinc en vue de former un revêtement qui comprend, en masse, 0,5% d'aluminium, 0,46% de fer, 0,03% de plomb et quelques impuretés résiduelles le reste étant constitué par du zinc.

L'épaisseur du revêtement ainsi déposé de manière classique est d'environ 11µm et l'épaisseur totale de la tôle revêtue est de 0,75mm.

Les échantillons 3 et 4 sont immergés dans un bain comprenant prinoipalement du zinc en vue de former un revêtement qui comprend en masse, 0,47% d'aluminium, 0,46% de fer, 0,028% de plomb et quelques impuretés résiduelles le reste étant constitué du zinc.

L'épaisseur du revêtement ainsi déposé de manière classique est d'environ 11 µm et l'épaisseur totale de la tôle revêtue est de 0,75mm. Les échantillons 2 et 4 sont ensuite placés dans une enceinte sous vide dont l'atmosphère est à une pression de 10⁻² Pa et l'on soumet les faces à revêtir desdits échantillons à un bombardement ionique au moyen d'ions de gaz neutre, obtenus à partir d'argon.

Les ions ont une énergie égale à 500 eV et la densité de courant ionique est de 0,16 mA/cm².

Le traitement de surface précité est effectué pendant une durée de 3mn. Les échantillons 1 et 3 ne sont pas traités et servent de témoin. On mesure alors sur chacune des faces principales des échantillons 1 à 4 la rugosité Ra au seuil de coupure de 2,5 caractérisant la microgéométrie de surface desdites faces. Les résultats obtenus sont répertoriés dans le tableau ci-après :

| | | | | |
|---|---|---|---|---|
| Echantillons | 1 | 2 | 3 | 4 |
| Ra (µm) | 1,25 | 1,45 | 1,55 | 2,00 |

On peut constater que les faces des tôles d'acier galvanisées à chaud traitées selon l'invention présentent une rugosité Ra plus élevée que celle des faces des tôles non traitées, propriété qui est généralement recherchée pour la mise en forme des tôles. On peut également constater que, selon l'invention, l'augmentation de rugosité ne nuit pas à l'aspect des tôles peintes.

### Essai 3 :

L'essai a pour but de montrer l'adhérence d'une peinture sur des tôles d'acier galvanisées à chaud traitées selon l'invention. Pour la mise en oeuvre de cet essai on utilise quatre échantillons de tôles d'acier préparés dans les mêmes conditions que dans l'essai 2.

Chacun des quatre échantillons est soumis à diverses opérations largement connues de l'art antérieur: dégraissage alcalin, rinçage, affinage, phosphatation tricationique, rinçage, passivation chromique, rinçage, étuvage.

Les échantillons sont ensuite soumis à une opération de cataphorèse de type PPG ED4 717/958 permettant d'appliquer une première couche de peinture d'épaisseur égale à 11µm sur chacun d'eux.

On effectue sur les échantillons un test dit de gravillonnage qui consiste à projeter une quantité définie de grenaille, (100ml) en deux passages sous une pression d'air de 2 bars, sur lesdits échantillons.

Un test de gravillonnage donne lieu à une cotation allant de 1 à 9 et qui est représentative du degré d'écaillage de la peinture, la cotation 1 faisant référence à l'aspect le moins dégradé.

Les résultats obtenus ont indiqué une cotation 1 pour l'ensemble des échantillons, montrant ainsi que le traitement selon l'invention de tôles d'acier galvanisées à chaud n'a aucune influence sur le bon comportement des dites tôles face au gravillonnage.

## Revendications

1. Procédé pour préparer une tôle en acier revêtue de zinc ou d'alliage de zinc pour une opération ultérieure de mise en peinture, ce procédé comprenant une étape dans laquelle on fait subir à ladite tôle sur au moins une des faces revêtues un bombardement ionique sous vide par des ions d'un gaz comprenant au moins un composant gazeux choisi parmi un gaz neutre et un gaz réactif, lesdits ions ayant une énergie et une densité suffisantes pour modifier l'état de surface de ladite tôle par érosion ionique, par effet thermo-ionique, ou par effet chimique, ou par combinaison d'au moins deux de ces phénomènes.

2. Procédé selon la revendication 1, selon lequel les ions ont une énergie comprise entre 500 et 2000 eV et de préférence comprise entre 750 et 1000 eV.

3. Procédé selon la revendication 1 ou 2, selon lequel les ions ont une densité comprise entre 10¹⁵ et 10¹⁸ ions/cm² et de préférence comprise entre 10¹⁶ et 10¹⁷ ions/cm².

4. Procédé selon l'une des revendications 1 à 3, selon lequel ledit traitement de surface est effectué sous une pression comprise entre 10² et 10⁻² Pa, et de préférence comprise entre 1 et 10⁻² Pa.

5. Procédé selon l'une des revendications 1 à 4, selon lequel le gaz neutre est choisi parmi l'argon, le xénon et le krypton.

6. Procédé selon l'une des revendications 1 à 5, selon lequel le gaz réactif est choisi parmi l'oxygène, le fluor, l'hydrogène, l'azote et les hydrocarbures volatils.

7. Procédé de mise en peinture d'une tôle en acier revêtue de zinc ou d'alliage de zinc, comprenant une première étape de préparation de ladite tôle suivant un procédé selon l'une quelconque des revendications 1 à 6, puis une deuxième étape où l'on effectue la mise en peinture de la tôle traitée.

8. Tôle d'acier revêtue comprenant une couche de base constituée de zinc ou d'alliage de zinc déposée sur l'acier et une couche de peinture appliquée sur ladite couche de base, caractérisée en ce que l'état de surface de la couche de base a été modifié, avant l'application de ladite couche de peinture par un traitement par bombardement ionique sous vide suivant un procédé selon l'une quelconque des revendications 1 à 6.

## Patentansprüche

1. Verfahren zur Herstellung eines Stahlblechs, das mit Zink oder einer Zinklegierung beschichtet ist und anschließend lackiert wird, wobei das Verfahren einen Schritt umfaßt, in dem das Blech auf mindestens einer der beschichteten Flächen einem Ionenbeschuß unter vakuum durch Ionen eines Gases ausgesetzt wird, das mindestens einen gasförmigen Bestandteil umfaßt, der ausgewählt ist aus einem inerten Gas und einem reaktiven Gas, wobei diese Ionen eine Energie und eine Dichte besitzen, die ausreichen, um den Zustand der Oberfläche des Blechs durch Ionenerosion, durch thermoionische Wirkung oder durch chemische Wirkung oder durch eine Kombination von mindestens zwei dieser Phänomene zu modifizieren.

2. Verfahren nach Anspruch 1, wobei die Ionen eine Energie zwischen 500 und 2000 eV und vorzugsweise zwischen 750 und 1000 eV haben.

3. Verfahren nach Anspruch 1 oder 2, wobei die Ionen eine Dichte zwischen 10¹⁵ und 10¹⁸ Ionen/cm² und vorzugsweise zwischen 10¹⁶ und 10¹⁷ Ionen/cm² haben.

4. Verfahren nach einem der Ansprüche 1 bis 3, wobei die Behandlung der Oberfläche unter einem Druck zwischen 10² und 10⁻² Pa und vorzugsweise zwischen 1 und 10⁻² Pa durchgeführt wird.

5. Verfahren nach einem der Ansprüche 1 bis 4, wobei das inerte Gas ausgewählt ist aus Argon, Xenon und Krypton.

6. Verfahren nach einem der Ansprüche 1 bis 5, wobei das reaktive Gas ausgewählt ist aus Sauerstoff, Fluor, Wasserstoff, Stickstoff und flüchtigen Kohlenwaserstoffen.

7. Verfahren zur Lackierung eines mit Zink oder einer Zinklegierung beschichteten Stahlblechs, umfassend einen ersten Schritt der Herstellung des Blechs nach einem Verfahren nach irgendeinem der Ansprüche 1 bis 6 und einen zweiten Schritt, in dem die Lackierung des behandelten Blechs durchgeführt wird.

8. Beschichtetes Stahlblech, umfassend eine Grundschicht aus Zink oder einer Zinklegierung, die auf dem Stahl abgelagert ist, und eine Lackschicht, die auf diese Grundschicht aufgetragen wird, dadurch gekennzeichnet, daß der Zustand der Oberfläche der Grundschicht vor dem Auftragen der Lackschicht durch eine Behandlung mit Ionenbeschuß unter Vakuum nach einem Verfahren nach irgendeinem der Ansprüche 1 bis 6 modifiziert worden ist.

## Claims

1. Process for preparing sheet steel coated with zinc or zinc alloy, for a subsequent painting operation, this process comprising a step in which the said sheet steel is subjected on at least one of he coated faces to ion bombardment under vacuum with ions of a gas comprising at least one gaseous component chosen from a neutral gas and a reactive gas, the said ions having sufficient energy and density to change the surface condition of the said sheet steel by ion erosion, by thermionic effect or by chemical effect, or by a combination of a least two of these phenomena.

2. Process according to claim 1, according to which the ions have an energy of between 500 and 2000 eV and preferably between 750 and 1000 eV.

3. Process according to Claim 1 or 2, according to which the ions have a density of between 10¹⁵ and 10¹⁸ ions/cm² and preferably between 10¹⁶ and 10¹⁷ ions/cm².

4. Proceas according to one of Claims 1 to 3, according to which the said surface treatment is carried out under a pressure of between 10² and 10⁻² Pa, and preferably between 1 and 10⁻² Pa.

5. Process according to one of Claims 1 to 4, according to which the neutral gas is chosen from argon, xenon and krypton.

6. Process according to one of Claims 1 to 5, according to which the reactive gas is chosen from oxygen, fluorine, hydrogen, nitrogen and volatile hydrocarbons.

7. Process for painting sheet steel coated with zinc or zinc alloy, comprising a first step of preparing the said sheet steel following a process according to any one of Claims 1 to 6, then a second step in which the treated sheet steel in painted.

8. Coated sheet steel comprising an undercoat consisting of zinc or zinc alloy deposited on the steel and a paint coat applied on the said undercoat, characterized in that the surface condition of the undercoat was changed, before application of the said paint coat, by a treatment by ion bombardment under vacuum following a process according to any one of Claims 1 to 6.
